# EUROPÄISCHE PATENTSCHRIFT

(11) **EP 1 200 648 B1**
(45) Veröffentlichungstag und Bekanntmachung des Hinweises auf die Patenterteilung: **21.07.2004**
(21) Anmeldenummer: 00943669.2
(22) Anmeldetag: 29.05.2000
(51) Int. Cl.: C30B 15/04, C30B 15/00, C30B 17/00

(54) **VERFAHREN ZUR HERSTELLUNG EINES SEGMENTIERTEN KRISTALLS**
METHOD FOR PRODUCING SEGMENTED CRYSTALS
PROCEDE DE PRODUCTION D'UN CRISTAL SEGMENTE

(30) Priorität: 04.08.1999 DE 19936651
(43) Veröffentlichungstag der Anmeldung: 02.05.2002
(73) Patentinhaber: Forschungsinstitut für mineralische und metallische Werkstoffe Edelsteine/Edelmetalle GmbH, 55743 Idar-Oberstein (DE)
(72) Erfinder: ACKERMANN, Lothar, D-55743 Idar-Oberstein (DE)
(74) Vertreter: Weber, Dieter, Dr.
(86) Internationale Anmeldenummer: PCT/DE2000/001782
(87) Internationale Veröffentlichungsnummer: WO 2001/011115

(56) Entgegenhaltungen:
- EP-A- 0 864 671
- FR-A- 1 112 725
- US-A- 2 753 280
- US-A- 5 394 420
- KIYOSHI SHIMAMURA ET AL: "A NEW CRYSTAL GROWTH METHOD FOR IN SITU CORE DOPING" JOURNAL OF CRYSTAL GROWTH,NL,NORTH-HOLLAND PUBLISHING CO. AMSTERDAM, Bd. 142, Nr. 3/04, 2. September 1994 (1994-09-02), Seiten 400-402, XP000468435 ISSN: 0022-0248
- NIKOLOV ET AL: "Effect of the hydrodynamics in high temperature solutions on the quality of pure and substituted YIG single crystals grown by the TSSG method" JOURNAL OF CRYSTAL GROWTH., Bd. 75, Nr. 2, Mai 1986 (1986-05), Seiten 269-276, XP002148997 NORTH-HOLLAND PUBLISHING CO. AMSTERDAM., NL ISSN: 0022-0248

## Beschreibung

Die vorliegende Erfindung betrifft ein Verfahren zur Herstellung eines Kristalls mit mindestens zwei Segmenten, die sich durch mindestens eine Eigenschaft unterscheiden, wobei der segmentierte Kristall direkt aus der Schmelze gezogen wird. Die verschiedenen Segmente können z. B. aus unterschiedlichen Materialien bestehen oder eine unterschiedliche Dotierung (unterschiedliche Konzentration oder unterschiedlichen Dotanden) aufweisen.

Die FR 1,112,725 beschreibt ein Verfahren zur Herstellung von P-N-Halbleiterkristallen. Hier wird ein Halbleiterkristall mit vorbestimmter Akzeptor- und/oder Donatordotierung aus der Schmelze gezogen, wobei zunächst ein Keinkristall in einer ersten Schmelzmischung gezogen wird und dann in einer zweiten Schmelzmischung weitergezogen wird, so daß ein Kristall mit einem P- und einem N-Segment gebildet wird.

Ein ähnliches Verfahren ist in der US 2,753,280 dargestellt, wobei hier sogar Drei- oder Mehrzonenkristalle gezogen werden.

Insbesondere in der Lasertechnik bieten optische Bauelemente, die aus verschiedenen Kristallsegmenten zusammengesetzt sind, erhebliche Einsatzvorteile. Bei laserdiodengepumpten und lampengepumpten Festkörperlasem sind bereits verschiedene Designs von zusammengesetzten segmentierten Laserkristallen bekannt. So können z. B. mit segmentierten Laserkristallen Mehr-Wellenlängenlaser (z. B. Nd:YAG-Er:YAG für Wellenlängen von λ=1064 nm und 2940 nm) verwirklicht werden. Die bekannten segmentierten Laserstäbe weisen eine unterschiedliche Dotierungskonzentration über die Stablänge auf.

Die auf dem Markt befindlichen segmentierten Kristalle werden mit Hilfe von zwei unterschiedlichen Verfahren hergestellt.

So wird z. B. zur Herstellung von Rubinlaserstäben mit undotierten Enden das Vemeuil-Kristallzüchtungsverfahren benutzt. Dabei wird die Flamme eines Knallgasbrenners senkrecht nach unten auf einen sich drehenden Impfkristall gerichtet. Ein Sauerstoffstrom "reißt" das pulverisierte Ausgangsmaterial mit sich. Dieses wird in der Flamme geschmolzen und führt am oberen Ende des Kristalls zu einem Kristallwachstum.

Der Vorteil des Vemeuil-Verfahrens, das auch Flammenschmelzverfahren genannt wird, liegt in der Tiegelfreiheit. Nachteilig sind jedoch die auftretenden hohen Temperaturunterschiede, die im allgemeinen zu Spannungen und Inhomogenitäten im Kristall führen. Zudem wird mit diesem Verfahren immer eine gekrümmte Verbindungslinie zwischen unterschiedlichen Segmenten erhalten.

Das andere in der Technik bekannte Verfahren zur Herstellung von segmentierten Laserstäben benutzt die "Bonding"-Technik. Hier werden Kristalle thermisch durch lonendiffusion zusammengefügt. Die zu verbindenden Kristallsegmente werden dazu getrennt gezüchtet und müssen auf eine Planarität von mindestens 1/10 der Laserwellenlänge poliert werden. Anschließend müssen die polierten Flächen kristallographisch orientiert zusammengefügt werden. Dieses Verfahren ist sehr zeitaufwendig und kann nur unter Reinraumbedingungen durchgeführt werden. Es ist folglich auch sehr kostenintensiv. Die US 5,394,420 beschreibt ein solches Verfahren.

Der vorliegenden Erfindung liegt daher die Aufgabe zugrunde, ein Verfahren zur Herstellung eines Kristalls mit mindestes zwei Segmenten bereitzustellen, das die Herstellung von segmentierten Kristallen mit hoher Kristallqualität und möglichst ebener Verbindungsfläche zwischen den einzelnen Segmenten ermöglicht und das sehr kostengünstig ist.

Diese Aufgabe wird dadurch gelöst, daß zumindest während des Ziehens eines zweiten Segmentes der Kristall mit einer Geschwindigkeit in Rotation versetzt wird, die der Inversionsgeschwindigkeit entspricht, so daß die Phasengrenze zwischen dem kristallisierten und noch flüssigen Material in einer Ebene etwa senkrecht zur Ziehrichtung verläuft.

Dies ist sowohl mit der Czochralski-Methode als auch mit der Flußmittel-Methode möglich.

Bei der Czochralski-Methode wird ein Kristall freitragend aus einer in einem Tiegel vorliegenden Schmelze unter genauer Kontrolle der Ziehgeschwindigkeit herausgezogen. Im allgemeinen wird dieses Verfahren der Kristallzüchtung mit einem dünnen Impfkristall der gewünschten Orientierung initiiert. Dieses Verfahren hat den Vorteil, daß der fertige Kristall nicht mehr mit dem Tiegel in Berührung kommt.

Für die Herstellung eines segmentierten Kristalls wird zunächst, zum Beispiel unter Zuhilfenahme eines orientierten Impfkristalls, ein Kristall bestimmter Zusammensetzung aus der Schmelze gezogen. Der Ziehprozeß wird dann unterbrochen, d. h. die Ziehgeschwindigkeit, mit welcher der Kristall aus der Schmelze gezogen wird, beträgt im wesentlichen Null, und die Zusammensetzung der Schmelze wird verändert. Anschließend wird der Ziehprozeß fortgesetzt und auf den Kristall wächst ein weiteres Segment mit einer anderen Zusammensetzung auf.

Besonders bevorzugt ist ein Verfahren, das die Schritte aufweist:
- Eintauchen eines Kristalls mit bestimmter Zusammensetzung in eine Schmelze anderer Zusammensetzung,
- Ankristallisation und
- Weiterziehen eines Kristallsegmentes mit der anderen Zusammensetzung.

Unter Ankristallisation wird der Vorgang beim Aufsetzen des Kristalls auf die Schmelze genannt. Dadurch, daß der Kristall vor dem Aufsetzen eine Temperatur weit unterhalb der Schmelztemperatur besitzt, wird an der Kontaktfläche zwischen Kristall und Schmelze Wärme über den Kristall abgeleitet und es kristallisieren spontan einige Gramm der Schmelze an dem Kristall an.

Wesentlich ist also, daß, nachdem der Kristall mit bestimmter Zusammensetzung gezogen worden ist, dieser aus der Schmelze entfemt wird, und erst in einem weiteren Schritt in eine Schmelze anderer Zusammensetzung eingetaucht wird.

Mit Hilfe dieses Verfahrens können sehr leicht große, segmentierte Einkristalle hergestellt werden. Bei der Kristallzüchtung bildet sich aber unter normalen Züchtungsbedingungen eine, von den thermischen Gradienten und dem Ausdehnungskoeffizienten der Schmelze abhängige, gebogene, konusförmige Wachstumsfront aus. Diese Wachstumsfront folgt der Schmelzisothermen. Diese Schmelzisotherme entsteht im allgemeinen durch eine vom Tiegelrand zum Zentrum des Tiegels gerichtete Schmelzkonvektion.

Meist sind aber segmentierte Kristalle, insbesondere segmentierte Laserkristalle, mit im wesentlichen ebenen Grenzflächen erwünscht.

Das erfindungsgemäße Verfahren zur Herstellung eines segmentierten Kristalls sieht daher vor, daß der Kristall während der Kristallzucht um seine eigene Achse rotiert. Durch die Rotation des Kristalls in der Schmelze wird die Abwärtskonvektion unter dem Kristall abgeschwächt, so daß die Schmelzisotherme einen ebeneren Verlauf nimmt.

Erfindungsgemäß rotiert der Kristall während der Kristallrotation mit der Inversionsrotationsgeschwindigkeit. Die Inversionsrotationsgeschwindigkeit, welche u.a. von dem Durchmesser des Kristalls abhängt, ist die Rotationsgeschwindigkeit, bei der die Schmelzisotherme horizontal verläuft, so daß auch eine horizontale Wachstumsfront ausgebildet wird.

Durch die Rotation des Kristalls während der Kristallzucht kann eine nahezu beliebig gebogene oder eine ebene Wachstumsfront eingestellt werden.

Auch ist es möglich, eine bereits bestehende gekrümmte oder ebene Wachstumsfront durch Veränderung der Rotationsgeschwindigkeit zu beeinflußen. So ist es z. B. möglich, einen undotierten oder dotierten Kristall mit einer gekrümmten konusförmigen Wachstumsfront in eine Schmelze anderer Zusammensetzung zu tauchen und dann durch langsame Erhöhung der Rotationsgeschwindigkeit bis zur Inversionsgeschwindigkeit ein Abschmelzen des Konus zu erreichen, um eine ebene Endfläche zu erhalten. Im Anschluß daran ist es dann möglich, durch Einleiten des Ziehprozesses, d.h. das langsame Herausziehen des Kristalls aus der Schmelze, die Kristallisation fortzusetzen.

Durch das Eintauchen eines Kristalls mit relativ großem Durchmesser (>30 mm) in eine typischerweise ca. 2000 °C heiße Schmelze erleidet der Kristall einen Temperaturschock und bildet Risse, die den ganzen Kristall zerstören können. Ist der einzutauchende Kristall auf der Unterseite konisch ausgebildet, so ist die Kontaktfläche beim Aufsetzen auf die Schmelze nur wenige mm im Durchmesser, so daß der Kristall keinen Schaden erleidet. Auch das weitere Eintauchen des gesamten konischen Unterteils in die heiße Schmelze verursacht keine Schäden im Kristall. Ist der konische Teil des Kristalls ganz in die Schmelze eingetaucht, so wird durch die anschließende Erhöhung der Rotation bis zur kritischen "Inversionsrotation" dieser Konus abgeschmolzen und dadurch eine ebene Kristallfront erhalten.

Auch das oben beschriebene Ankristallisieren erzeugt oftmals Störungen, wie z. B. Bläschen, an der Kristallgrenzfläche. Auch hier ist überraschenderweise eine Verbesserung der Kristallqualität möglich, wenn zumindest ein Teil des ankristallisierten Materials daraufhin wieder abgeschmolzen wird.

Eine besonders hohe Kristallqualität kann somit durch die folgenden Verfahrensschritte erreicht werden:
- Ziehen eines Kristalls mit bestimmter Zusammensetzung, eventuell unter Verwendung eines kristallographisch orientierten Impfkristalls, mit niedriger Kristallrotation bis zur gewünschten Kristallänge,
- Herausnehmen des Kristalls aus der Schmelze,
- Eintauchen des Kristalls mit notwendigerweise konusförmigem Ende in eine Schmelze anderer Zusammensetzung,
- Ankristallisation,
- Kontinuierliche Erhöhung der Kristallrotationsgeschwindigkeit bis zur Inversionsgeschwindigkeit, wodurch der Konus abgeschmolzen wird,
- Weiterziehen des Kristalls.

Für den Fall, daß der segmentierte Kristall mehr als zwei Segmente erhalten soll, kann es von Vorteil sein, wenn die Rotationsgeschwindigkeit vor Erreichen der Ziellänge des betreffenden Segmentes wieder reduziert wird, so daß das Kristallende wieder ein konusförmiges Ende erhält. Dieses wird dann in eine Schmelze anderer Zusammensetzung eingetaucht und durch schrittweises Erhöhen der Kristallrotationsgeschwindigkeit dann wieder abgeschmolzen bevor die Züchtung des nächsten Segments erfolgt.

Selbstverständlich ist es aber auch möglich, einen undotierten oder dotierten Kristall mit ebener Phasengrenzfläche in eine Schmelze anderer Zusammensetzung einzutauchen und nach der Ankristallisation den Kristall mit gekrümmter oder mit ebener Wachstumsfront weiterzuziehen. Bei manchen Kristallen besteht dann allerdings die Gefahr von Rißbildung an der Grenzfläche.

Eine spezielle Ausführungsform dieses Verfahrens sieht vor, daß zunächst ein undotierter Kristall oder ein Kristall mit niedriger Dotierung mit ebener Wachstumsfront bis zur Ziellänge gezogen wird, der Ziehprozeß dann unterbrochen wird, die Schmelze daraufhin dotiert bzw. höher dotiert wird, während der Kristall in der Schmelze eingetaucht bleibt. Als nächstes wird dann der Ziehprozeß fortgesetzt, so daß sich ein Kristallsegment mit dotierter bzw. höher dotierter Zusammensetzung bildet. So sind sogar Kristalle herstellbar, die einen kontinuierlichen Konzentrationsübergang über zumindest einen Teil der Kristallänge zeigen. Dies ist insbesondere dann von Vorteil, wenn sich durch die Dotierung die Gitterkonstanten ändem. Durch den kontinuierlichen Übergang von einem Segment mit einer Dotierungskonzentration zu einem Segment mit anderer Dotierungskonzentration wird das Auftreten von Kristallfehlern (z. B. Versetzungen, Komgrenzen) vermieden.

Beim Flußmittelverfahren hingegen wird eine Schmelze benutzt, die nicht der Zusammensetzung des zu ziehenden Kristalls entspricht. Die einzelnen Komponenten des Kristalls werden indes in dieser Schmelze (Flußmittel) gelöst. Dieses Verfahren hat den Vorteil, daß bestimmte Kristalle deutlich unterhalb der Schmelztemperatur des zu züchtenden Kristalls gezüchtet werden können. Auch hier wird, ähnlich dem Czochralski-Verfahren, im allgemeinen zunächst ein orientierter Keimkristall auf die Schmelze aufgesetzt. Dann wird über eine allmähliche Absenkung der Temperatur der Schmelze ein Kristallwachstum herbeigeführt. Der Kristall wächst hierbei in die Schmelze und wird im allgemeinen erst nach Beendigung der Züchtung aus der Schmelze herausgezogen. Es gibt jedoch auch Flußmittelverfahren, z. B. das "top seeded"-Verfahren, bei dem der Kristall während des Wachstums langsam aus der Schmelze herausgezogen wird, so daß aus einem relativ kleinen Tiegelvolumen ein relativ großer Kristall gezogen werden kann.

Das beschriebene Verfahren offenbart die Möglichkeit, segmentierte Kristalle sehr kostengünstig, mit großen geometrischen Abmessungen und vor allem ausgezeichneter Qualität herzustellen. Kleinere Kristalle nahezu beliebiger Geometrie können durch Ausbohren oder Aussägen der großen Kristalle erhalten werden.

Weitere Vorteile, Merkmale und Anwendungsmöglichkeiten des Verfahrens werden deutlich anhand der in den folgenden Figuren gezeigten Anwendungsbeispielen. Es zeigen:

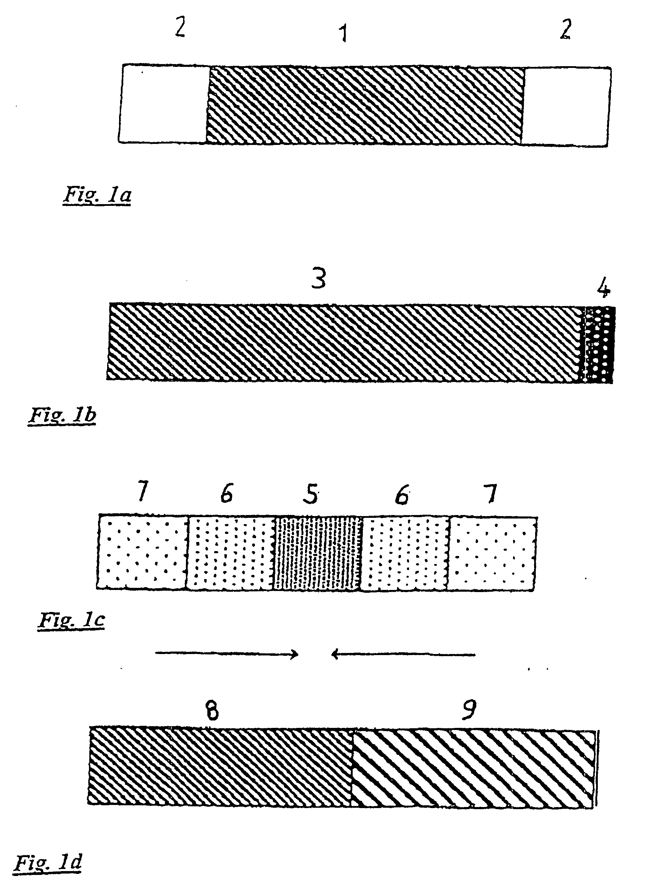

- Figur 1a: einen Laserkristall mit undotierten Enden,
- Figur 1b: einen Laserkristall mit angewachsenem passiven Q-switch Kristall,
- Figur 1c: einen Laserkristall, zusammengesetzt aus Segmenten mit unterschiedlichen Dotierungskonzentrationen und
- Figur 1d: einen Laserkristall, zusammengesetzt aus Segmenten mit unterschiedlichen Dotierungen.

Wie in Figur 1a gezeigt, ist es mit Hilfe des beschriebenen Verfahrens möglich, Laserkristalle herzustellen, deren Enden 2 weniger stark oder überhaupt nicht dotiert sind. So können beispielsweise Laserstäbe 1 aus dotiertem YAG oder YVO₄ mit undotierten Enden hergestellt werden. Dadurch wird die Selbstsabsorption der ungepumpten Enden 2 vermieden. Außerdem ist es möglich, die Resonatorspiegel des Lasers auf die undotierten Enden 2 der Laserstäbe aufzudampfen. Durch die undotierten Enden 2 wird die thermische Deformation der Spiegeloberflächen vermieden.

Figur 1b zeigt einen Laserkristall 3 mit einem angewachsenen passiven Q-switch Kristall 4. Dieser Q-switch Kristall 4 hat eine bestimmte Dotierung, so daß er als sättigbarer Absorber wirkt und als passiver Güteschalter (Q-switch) zur Modulierung von Laserstrahlen im kHz-Bereich eingesetzt werden kann. So kann z. B. ein Cr⁴⁺-dotierter YAG-Kristall als Güteschalter für die Laserwellenlänge von Nd:YAG (1064 nm) eingesetzt werden.

Normalerweise müssen hierzu Cr⁴⁺:YAG-Scheibchen in den Strahlengang eingebracht werden und beidseitig antireflexbeschichtet werden. Jede Grenzfläche gegen Luft sorgt aber für unerwünschte Verluste. Daher ist ein segmentierter Laserstab mit integriertem Güteschalter 4 äußerst vorteilhaft.

Wie in Figur 1c zu sehen ist, kann mit Hilfe dieses Verfahrens ein segmentierter Kristall hergestellt werden, der nahezu beliebig viele Segmente (5, 6, 7) mit unterschiedlichen Dotierungskonzentrationen aufweist. Abgebildet ist ein Laserkristall mit fünf Segmenten, wobei die Dotierungskonzentration von außen nach innen zunimmt. Dadurch können Mehrwellenlängenlaser verwirklicht werden.

Figur 1d zeigt schließlich ein einfaches Beispiel eines Kristalls bestehend aus zwei Segmenten mit unterschiedlichen Dotierungsarten.

Das beschriebene Verfahren funktioniert im Prinzip mit allen bekannten Laserkristallen. Es ist aber selbstverständlich nicht nur auf Laserkristalle beschränkt.

## Patentansprüche

1. Verfahren zur Herstellung eines Kristalls mit mindestens zwei Segmenten, die sich hinsichtlich ihrer Zusammensetzung unterscheiden, wobei der Kristall aus der Schmelze gezüchtet wird, **dadurch gekennzeichnet, daß** zumindest während des Ziehens eines zweiten Segmentes der Kristall mit einer Geschwindigkeit in Rotation versetzt wird, die der Inversionsgeschwindigkeit entspricht, so daß die Phasengrenze zwischen dem kristallisierten und noch flüssigen Material in einer Ebene in etwa senkrecht zur Ziehrichtung verläuft.

2. Verfahren nach Anspruch 1, **dadurch gekennzeichnet, daß** nach dem Ziehen eines ersten Kristallsegmentes eine gegebenenfalls unebene Phasengrenzfläche unter Rotation des Kristalls mit Inversionsrotationsgeschwindigkeit abgeschmolzen wird.

3. Verfahren nach Anspruch 1, **dadurch gekennzeichnet, daß** der Kristall mit der Czochralski-Methode aus der Schmelze gezogen wird.

4. Verfahren nach einem der Ansprüche 1 bis 3, **dadurch gekennzeichnet, daß** der Kristall ein Laserkristall ist.

5. Verfahren nach einem der Ansprüche 1 bis 4, **dadurch gekennzeichnet, daß** der Kristall ein Einkristall ist.

6. Verfahren nach Anspruch 2, 4 oder 5, **dadurch gekennzeichnet, daß** es die Schritte aufweist Eintauchen eines Kristalls mit bestimmter Zusammensetzung in eine Schmelze anderer Zusammensetzung,
Ankristallisation und
Weiterziehen eines Kristallsegmentes mit der anderen Zusammensetzung.

7. Verfahren nach Anspruch 6, **dadurch gekennzeichnet, daß** das Verfahren nach dem Ankristallisieren zusätzlich den Schritt aufweist:
mindestens teilweise Abschmelzen des ankristallisierten Materials durch Eintauchen in die Schmelze vorzugsweise während der Kristall rotiert.

8. Verfahren nach Anspruch 3, **dadurch gekennzeichnet, daß** es die Schritte aufweist:
Eintauchen eines Kristalls mit einer ersten Zusammensetzung in eine Schmelze mit einer zweiten Zusammensetzung und
Aufwachsen eines Kristalls mit einer dritten Zusammensetzung, während die Temperatur der Schmelze abgesenkt wird und/oder der Kristall aus der Schmelze gezogen wird.

9. Verfahren nach einem der Ansprüche 1 bis 8, **dadurch gekennzeichnet, daß** es zusätzlich als letztes den Schritt aufweist, daß ein segmentierter Kristall vorbestimmter Geometrie durch Ausbohren oder Aussägen aus dem gezüchteten Kristall hergestellt wird.

10. Verfahren nach Anspruch 1, **dadurch gekennzeichnet, daß** der Kristall mit der Flußmittelmethode aus der Schmelze gezüchtet wird.

11. Verfahren nach Anspruch 1, **gekennzeichnet durch** die folgenden Merkmale:
a) Ziehen eines Kristalls mit bestimmter Zusammensetzung, eventuell unter Verwendung eines kristallographisch orientierten Impfkristalls, mit niedriger Kristallrotation bis zur gewünschten Kristallänge,
b) Herausnehmen des Kristalls aus der Schmelze,
c) Eintauchen des Kristalls mit notwendigerweise konusförmigem Ende in eine Schmelze anderer Zusammensetzung,
d) Ankristallisation,
e) kontinuierliche Erhöhung der Kristallrotationsgeschwindigkeit bis zur Inversionsgeschwindigkeit, wodurch der Konus abgeschmolzen wird,
f) Weiterziehen des Kristalls.

## Claims

1. Method for manufacturing a crystal with at least two segments which differ in respect of their composition, wherein the crystal is grown from the molten mass, **characterised in that** during the growth of a second segment the crystal is rotated at a speed which corresponds to the inversion speed, so that the phase boundary between the crystallised material and the material which is still fluid extends in a plane approximately perpendicularly to the direction of growth.

2. Method according to claim 1, **characterised in that** after the growth of a first crystal segment any uneven phase boundary surface is melted away by rotating the crystal at inversion rotation speed.

3. Method according to claim 1, **characterised in that** the crystal is drawn from the molten mass using the Czochralski method.

4. Method according to one of claims 1 to 3, **characterised in that** the crystal is a laser crystal.

5. Method according to one of claims 1 to 4, **characterised in that** the crystal is a single crystal.

6. Method according to claim 2, 4 or 5, **characterised in that** it has the steps of:
immersing a crystal with a specific composition in a molten mass with a different composition,
crystallising on, and
further drawing of a crystal segment with the different composition.

7. Method according to claim 6, **characterised in that** the method, following crystallising on, has the further step of:
at least partial melting away of the material crystallised on by immersion in the molten mass, preferably while the crystal rotates.

8. Method according to claim 3, **characterised in that** it has the steps of:
immersing a crystal having a first composition in a molten mass with a second composition, and
growing a crystal with a third composition, while the temperature of the molten mass is reduced and/or the crystal is drawn from the molten mass.

9. Method according to one of claims 1 to 8, **characterised in that** it additionally has as the last step that a segmented crystal with a pre-determined geometry is manufactured by being drilled out or sawn out of the grown crystal.

10. Method according to claim 1, **characterised in that** the crystal is grown from the molten mass by the solvent method.

11. Method according to claim 1, **characterised by** the following features:
a) drawing of a crystal with a specific composition, possibly using a crystallographically orientated seed crystal, with low speed crystal rotation, to the desired crystal length,
b) removal of the crystal from the molten mass,
c) immersion of the crystal with a necessarily conical end into a molten mass with a different composition,
d) crystallising on,
e) continuous increase in the crystal rotation speed up to the inversion speed, whereby the cone is melted away,
f) further drawing of the crystal.

## Revendications

1. Procédé de fabrication d'un cristal comportant au moins deux segments qui se distinguent par leur composition, le cristal étant développé à partir de matière en fusion, **caractérisé en ce qu'**au moins pendant le tirage d'un deuxième segment le cristal est déplacé en rotation à une vitesse qui correspond à la vitesse d'inversion de sorte que la limite de phase entre la matière cristallisée et la matière encore liquide s'étend dans un plan sensiblement perpendiculaire à la direction de tirage.

2. Procédé selon la revendication 1, **caractérisé en ce que** après le tirage d'un premier segment de cristal une phase intermédiaire le cas échéant inégale est séparée par fusion en faisant tourner le cristal à la vitesse de rotation d'inversion.

3. Procédé selon la revendication 1, **caractérisé en ce que** le cristal est tiré de la matière en fusion par le procédé de Czochralski.

4. Procédé selon l'une des revendications 1 à 3, **caractérisé en ce que** le cristal est un cristal pour laser.

5. Procédé selon l'une des revendications 1 à 4, **caractérisé en ce que** le cristal est un monocristal.

6. Procédé selon la revendication 2, 4 ou 5, **caractérisé en ce qu'**il comporte les étapes consistant à :
plonger un cristal d'une composition déterminée dans une matière en fusion d'une autre composition,
réaliser une cristallisation rapportée et
poursuivre le tirage d'un segment de cristal de l'autre composition.

7. Procédé selon la revendication 6, **caractérisé en ce que** le procédé comporte en plus après la cristallisation rapportée l'étape consistant à :
retirer au moins partiellement par fusion la matière cristallisée de façon rapportée en plongeant dans la matière en fusion avantageusement pendant la rotation du cristal.

8. Procédé selon la revendication 3, **caractérisé en ce qu'**il comporte les étapes consistant à :
plonger un cristal d'une première composition dans une matière en fusion d'une deuxième composition et
réaliser l'épitaxie d'un cristal d'une troisième composition pendant l'abaissement de la température de la matière en fusion et/ou le tirage du cristal de la matière en fusion.

9. Procédé selon l'une des revendication 1 à 8, **caractérisé en ce qu'**il comporte en plus une dernière étape consistant à :
fabriquer un cristal segmenté, de géométrie déterminée au retrait du cristal développé, par perçage ou sciage.

10. Procédé selon la revendication 1, **caractérisé en ce que** le cristal est développé à partir de la matière en fusion par le procédé de fluxage.

11. Procédé selon la revendication 1, **caractérisé par** les étapes suivantes :
a) tirer, jusqu'à la longueur de cristal souhaitée, un cristal de composition déterminée et de faible rotation de cristal, en utilisant éventuellement un germe orienté du point de vue cristallographique,
b) retirer le cristal de la matière en fusion,
c) plonger le cristal, dont l'extrémité est nécessairement conique, dans une matière en fusion d'une autre composition,
d) effectuer la cristallisation rapportée,
e) augmenter en continu la vitesse de rotation du cristal jusqu'à atteindre la vitesse d'inversion de façon à retirer le cône par fusion,
f) poursuivre le tirage du cristal.
